# EUROPÄISCHE PATENTSCHRIFT

(11) **EP 0 815 156 B1**
(45) Veröffentlichungstag und Bekanntmachung des Hinweises auf die Patenterteilung: **09.07.2003**
(21) Anmeldenummer: 96907450.9
(22) Anmeldetag: 13.03.1996
(51) Int. Cl.: C08G 61/10, H05B 33/14, H01B 1/12

(54) **OLIGO-p-PHENYLEN-EINHEITEN ENTHALTENDE POLYMERE, VERFAHREN ZU IHRER HERSTELLUNG SOWIE IHRE VERWENDUNG**
OLIGO-p-PHENYLENE-UNIT-CONTAINING POLYMERS, PROCESS FOR THEIR PRODUCTION AND THEIR USE
POLYMERES CONTENANT DES UNITES OLIGO-p-PHENYLENE, PROCEDE PERMETTANT DE LES PREPARER ET UTILISATION

(30) Priorität: 20.03.1995 DE 19509451
(43) Veröffentlichungstag der Anmeldung: 07.01.1998
(73) Patentinhaber: Covion Organic Semiconductors GmbH, 65926 Frankfurt (DE)
(72) Erfinder: KREUDER, Willi, D-55126 Mainz (DE); NEHER, Dieter, D-55128 Mainz (DE); REMMERS, Marcus, D-55128 Mainz (DE)
(74) Vertreter: Luderschmidt, Schüler & Partner GbR
(86) Internationale Anmeldenummer: EP9601066
(87) Internationale Veröffentlichungsnummer: WO96029356

(56) Entgegenhaltungen:
- WO-A-92/03490
- WO-A-94/29883
- DE-A- 3 735 971
- DE-A- 4 435 047
- GB-A- 1 092 824
- FASERFORSCHUNG U. TEXTILTECHN., Bd. 25, 1974, Seiten 108-108-111, XP000571152 HÖRHOLD, H.-H. ET AL.: "Unters. über polyarylenvinylene" in der Anmeldung erwähnt
- SYNTHETIC METALS, Bd. 10, 1985, LAUSANNE, Seiten 181-191, XP002008254 FEAST, W.J. ET AL.: "Optical absorption and ...." in der Anmeldung erwähnt
- CHEMICAL ABSTRACTS, vol. 72, no. 20, 18.Mai 1970 Columbus, Ohio, US; abstract no. 101141, XP002008255 & PLASTE KAUT, Bd. 17, Nr. 2, 1970, Seiten 84-88, HÖRHOLD, H.H. ET AL.: "Poly(arylenecyanoethylenes)..."
- CHEMICAL ABSTRACTS, vol. 110, no. 16, 17.April 1989 Columbus, Ohio, US; abstract no. 146154, XP002008256 & DD 259 058 A (FRIEDRICH-SCHILLER UNIV) 10.August 1988
- CHEMICAL ABSTRACTS, vol. 90, no. 26, 25.Juni 1979 Columbus, Ohio, US; abstract no. 204564, XP002008257 & ACTA POLYM., Bd. 30, Nr. 2, 1979, Seiten 86-92, HÖRHOLD, H.H. ET AL.: "Studies on poly(arylenevinylenes)..."
- CHEMICAL ABSTRACTS, vol. 106, no. 10, 9.März 1987 Columbus, Ohio, US; abstract no. 67773, XP002008258 & MACROMOLECULES, Bd. 20, Nr. 2, 1987, Seiten 461-462, DROSKE, J.P. ET AL.: "Synthesis of a new poly(arylenedifluorovinylene)"
- CHEMICAL ABSTRACTS, vol. 116, no. 6, 10.Februar 1992 Columbus, Ohio, US; abstract no. 42331, XP002008259 & SYNTH. MET. , Bd. 45, Nr. 1, 1991, Seiten 107-117, MAHRT, R.F. ET AL.: "Light and heavy excitonic polarons..."
- CHEMICAL ABSTRACTS, vol. 115, no. 14, 7.Oktober 1991 Columbus, Ohio, US; abstract no. 136900, XP002008260 & POLYMER, Bd. 32, Nr. 10, 1991, Seiten 1857-1861, GREINER, A. ET AL.: "Aspects of synthesis..."
- CHEMICAL ABSTRACTS, vol. 109, no. 2, 11.Juli 1988 Columbus, Ohio, US; abstract no. 15430, XP002021803 & MACROMOLECULES, Bd. 21, Nr. 6, Seiten 1859-1863, BROWN, I.M. ET AL. : "Charge transfer complexes..."
- CHEMICAL ABSTRACTS, vol. 118, no. 8, 22.Februar 1993 Columbus, Ohio, US; abstract no. 60204, XP002021804 & J. POLYM.SCI.,PART A:POLYM CHEM., Bd. 30, Nr. 12, Seiten 2503-2510, BOCHMANN, M. ET AL.: "Synthesis of poly(arylene ethynes)..."
- CHEMICAL ABSTRACTS, vol. 123, no. 2, 10.Juli 1995 Columbus, Ohio, US; abstract no. 10174, XP002021805 & J.ANAL.CHEM., Bd. 50, Nr. 4, Seiten 394-396, OBTEMPERANSKAYA, A.N. ET AL.: "Spectrometric determination..."
- CHEMICAL ABSTRACTS, vol. 111, no. 4, 24.Juli 1989 Columbus, Ohio, US; abstract no. 24019, XP002021806 & POLYM. MATER. SCI. ENG., Bd. 60, 1989, Seite 762-766 WU, XIAOSONG ET AL.: "New rigid-rod monomers and polymers"
- CHEMICAL ABSTRACTS, vol. 107, no. 10, 7.September 1987 Columbus, Ohio, US; abstract no. 78286, XP002021807 & J. POLYM. SCI. PART A: POLYM CHEM., Bd. 25 , Nr. 3, 1987, Seiten 839-846, TRUMBO, D.L. ET AL.: "Polymerization using palladium (II) salts ..."
- RESEARCH DISCLOSURE, Nr. 332, 1.Dezember 1991, Seite 971 XP000274687 "PREPARING CONTINUOUS PPV-CONTAINING FILMS FROM PARYLENE"
- CHEMICAL ABSTRACTS, vol. 112, no. 8, 19.Februar 1990 Columbus, Ohio, US; abstract no. 57151, XP002021808 & POLYM.PREPR(AM.CHEM.SOC.,DIVPOLYM.CHEM.), Bd. 30, Nr. 2, 1989, Seite 503-504 MALLON, J.J. ET AL.: "All-hydrocarbon liquid-crystalline polymers"
- CHEMICAL ABSTRACTS, vol. 116, no. 24, 15.Juni 1992 Columbus, Ohio, US; abstract no. 236295, XP002021809 & MACROMOLECULES, Bd. 25, Nr. 11, 1992, Seite 2789-2795 KANTOR, S.W. ET AL.: "Thermotropic hydrocarbon..."
- CHEMICAL ABSTRACTS, vol. 95, no. 4, 27.Juli 1981 Columbus, Ohio, US; abstract no. 25689, XP002021810 & J.POLYM.SCI.,POLYM.CHEM.ED., Bd. 19, Nr. 5, 1981, Seiten 1273-1277, FUJITA, T. ET AL.: "polymerization of diphenoquinodimethanes..."
- CHEMICAL ABSTRACTS, vol. 123, no. 20, 13.November 1995 Columbus, Ohio, US; abstract no. 257675, XP002021811 & J.MATER CHEM, Bd. 5, Nr. 9, 1995, Seite 1297-1308 UTLEY,J.H.P. ET AL.: "electroorganic reactions..."
- MACROMOLECULES, Bd. 26, Nr. 15, 26.Juli 1993, Seiten 3758-3763, XP000382865 KANTOR, S.W.: "Thermotropic hydrocarbon main-chain.."

## Beschreibung

Es besteht ein hoher industrieller Bedarf an großflächigen Festkörper-Lichtquellen für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Als Alternative zu herkömmlichen Anzeige- und Beleuchtungselementen, wie Glühlampen, Gasentladungslampen und nicht selbstleuchtenden Flüssigkristallanzeigeelementen, sind bereits seit einiger Zeit Elektrolumineszenz (EL)-materialien und -vorrichtungen, wie lichtemittierende Dioden (LED), in Gebrauch.

Neben anorganischen Elektrolumineszenzmaterialien und -vorrichtungen sind seit etwa 30 Jahren auch niedermolekulare, organische Etektrolurnineszenimaterialien und -vorrichtungen bekannt (siehe z.B. US-A-3,172,862). Bis vor kurzem waren aber solche Vorrichtungen in ihrer praktischen Anwendbarkeit stark eingeschränkt.

In der WO 90/13148 und der EP-A O 443 861 werden Elektrolumineszenzvorrichtungen beschrieben, die einen Film aus einem konjugierten Polymer als lichtemittierende Schicht (Halbleiterschicht) enthalten. Solche Vorrichtungen bieten zahlreiche Vorteile, wie die Möglichkeit, großflächige, flexible Displays einfach und kostengünstig herzustellen. Im Gegensatz zu Flüssigkristalldisplays sind Elektrolumineszenzdisplays selbstleuchtend und benötigen daher keine zusätzliche rückwärtige Beleuchtungsquelle.

Eine typische Vorrichtung nach der WO 90/13148 besteht aus einer lichtemittierenden Schicht in Form eines dünnen, dichten Polymerfilms (Halbleiterschicht), der mindestens ein konjugiertes Polymer enthält. Eine erste Kontaktschicht steht in Kontakt mit einer ersten Oberfläche, eine zweite Kontaktschicht mit einer weiteren Oberfläche der Halbleiterschicht. Der Polymerfilm der Halbleiterschicht hat eine genügend geringe Konzentration von extrinsischen Ladungsträgern, so daß beim Anlegen eines elektrischen Feldes zwischen den beiden Kontaktschichten Ladungsträger in die Halbleiterschicht eingebracht werden, wobei die eine Kontaktschicht positiv gegenüber der anderen wird, und die Halbleiterschicht Strahlung aussendet. Die in solchen Vorrichtungen verwendeten Polymere sind konjugiert. Unter konjugiertem Polymer versteht man ein Polymer, das ein delokalisiertes Elektronensystem entlang der Hauptkette besitzt. Das delokalisierte Elektronensystem verleiht dem Polymer Halbleiterefgenschaften und gibt ihm die Möglichkeit, positive und/oder negative Ladungsträger mit hoher Mobilität zu transportieren.

In der WO 90/13148 ist als polymeres Material für die lichtemittierende Schicht Poly-(p-phenylen-vinylen) beschrieben, und es wird vorgeschlagen, die Phenylgruppe in einem solchen Material durch ein heterocyclisches oder ein kondensiertes, carbocyclisches Ringsystem zu ersetzen. Daneben wird auch Poly(p-phenylen), PPP, als elektrolumineszierendes Material verwendet (G. Grem, G. Ledetzky, B. Ullrich, G. Leising, Synth. Met. **1992**, 51, 383). Das Hauptproblem bei der Synthese und Verarbeitung von PPP ist darin zu sehen, daß dieser Stoff schon bei sehr geringen Polymerisationsgraden unlöslich und unschmelzbar ist. Über sogenannte Precursor-Routen (siehe z.B. D.G.H. Ballard et al., J. Chem. Soc. Chem. Com. **1983**, 954) gelang es, höhermolekulares PPP zu synthetisieren und auf der Stufe eines Präpolymers zu verarbeiten. Jedoch zeigen diese Materialien unvollständige Aromatisierung und/oder ortho-Verknüpfungen sowie andere Strukturdefekte. Um die Verarbeitbarkeit des PPP zu erhöhen und die Synthese von Material mit höherem Polymerisationsgrad zu ermöglichen, wurden bereits Derivate mit Alkyl- bzw. Alkoxyseitenketten dargestellt (F.L. Klavetter, G.G. Gustavson, A.J. Heeger, PMSE-Meeting Chicago **1993**, 69, 153), die eine erhöhte Löslichkeit aufweisen.

In der GB-A-1,092,824 wird Poly-(p-blphenylen-vinylen) beschrieben, das durch Dehydrohalogenierung von Dihalogen-p-xylol-Derivaten oder durch Wittig-Reaktion (H.H. Hörhold, J. Opfermann, Faserforschung und Textiltechnik **1974**, 25, 108) dargestellt werden kann. Mit der ersten Methode wird jedoch keine vollständige Eliminierung erreicht. Des weiteren ist bei beiden Synthesen der Gehalt an cis-kvntigurierten Doppelbindungen zum Teil erheblich, Poly-(pbiphenylen-vinylen) ist außerdem in allen bekannten Lösungsmitteln unlöslich. Es kann nur als Niederschlag aus Lösung gewonnen werden, wobei dessen weitere Verarbeitung nur mit Hilfe von z.B. Sintertechniken möglich ist. Eine Herstellung von homogenen, dünnen Polymerfilmen ist also nicht möglich.

Eine Steigerung der Löslichkeit von Poly-(p-biphenylen-vinylenl wird dadurch erreicht, daß an der Biphenyleneinheit in den 2,2'-Positionen Methylsubstituenten (A. Greiner, H. Martelock, A. Noll, N. Siegfried, W. Heitz, Polymer **1991**, 32, 1857) eingeführt werden, was aber eine erhebliche Verdrillung der beiden Phenyleinheiten zur Folge hat, wodurch sich sowohl das Maximum der Elektrolumineszenzemission ungünstig verschiebt als auch die Quantenausbeute der Elektrolumineszenz durch die Herabsetzung der Konjugation verschlechtert.

Die starke Blauverschiebung des UV-Absorptionsmaximums bei der perchlorierten Form des Poly-(p-biphenylen-vinylens) (P. Fors, L. Juliá, J. Riera, J.M. Tura, J. Sauló, J. Polym. Sci., Part A: Polym. Chem. **1992**, 30, 2489) zeigt, daß die vier sehr voluminösen Chlorsubstituenten in allen 2-Positionen der Phenyl-Phenyl-Bindung gleiche Probleme verursachen. Darüber hinaus sind polychtorierte Biphenyle stark toxisch und ökologisch belastend.

Obwohl mit einigen dieser Materialien gute Ergebnisse erzielt wurden, ist beispielsweise die Farbreinheit noch unbefriedigend. Weiterhin ist es mit den bisher bekannten Polymeren kaum möglich, eine blaue oder weiße Emission zu erzeugen.

Die Substitution an der Doppelbindung eines Poly-(4,4'-biphenylen-vinylens) wurde wegen der präparativen Schwierigkeiten bisher nur in Form zweier Phenylsubstituenten durchgeführt (W.J. Feast et al., Synthetic Metals **1985**, 10, 181). Die mit dieser Synthese hergestellten Substanzen weisen jedoch keine sehr hohen Molekulargewichte auf und es wurde ein hoher, nicht näher zu bestimmender Anteil an Doppelbindungen, bei denen die Polymerkette sich in cis-Stellung befindet, nachgewiesen.

Da zudem die Entwicklung von Elektrolumineszenzmaterialien, insbesondere auf Grundlage von Polymeren, noch in keiner Weise als abgeschlossen betrachtet werden kann, sind die Hersteller von Beleuchtungs- und/oder Anzeigevorrichtungen an den unterschiedlichsten Elektrolumineszenzmaterialien für solche Vorrichtungen interessiert.

Mit Hilfe von Modellrechnungen wurde theoretisch vorhergesagt, wie in Copolymeren aus reinem Poly-(p-phenyten) und Polyacetylen die energetischen Lagen von HOMO und LUMO durch das Verhältnis der Monomere beeinflußt werden (F. Meyers, A.J. Heeger, J.L. Brédas, J. Chem. Phys. **1992**, 97, 2750). Dies konnte bisher jedoch experimentell noch nicht verifiziert werden.

Aufgabe der vorliegenden Erfindung war es, neue Elektrofumineszenzmaterialien bereitzustellen, die in organischen Solventien löslich sind, und die bei Verwendung in Beleuchtungs- und/oder Anzeigevorrichtungen geeignet sind, das Eigenschaftsprofil dieser Vorrichtungen zu verbessern.

Es wurde nun überraschend gefunden, daß bestimmte Derivate des Poly[(oligop-phenylen)-vinylens] eine verbesserte Löslichkeit in organischen Solventien aufweisen und zur Erzeugung blauer, blaugrüner, grüner und weißer Elektrolumineszenz gut geeignet sind.

Gegenstand der Erfindung ist daher ein Oligo-p-phenyleneinheiten enthaltendes Polymer, das mindestens ein Strukturelement der allgemeinen Formel (AₖB)ₙ enthält, wobei die Symbole und Indizes folgende Bedeutungen haben:
- A: ist gleich oder verschieden 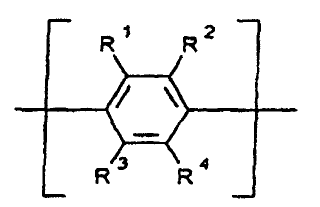
- B: ist gleich oder verschieden 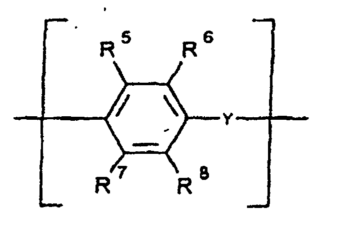
- Y: ist gleich oder verschieden -CR⁹=CR¹⁰-; R¹, R², R³, R⁴, R⁵, R⁶, R⁷, R⁸, R⁹, R¹⁰, sind in den einzelnen Strukturelementen unabhängig voneinander gleich oder verschieden H, eine geradkettige oder verzweigte Alkylkette mit 1 bis 22 C-Atomen, wobei eine oder mehrere nicht benachbarte CH₂-Gruppen auch durch -O-, -S-, -SO₂-, -COO-, -OOC- und/oder Phenylen, vorzugsweise 1,4-Phenylen, ersetzt sein können, Aryl- oder Aryloxygruppen, vorzugsweise mit 4 bis 14 C-Atomen, wobei der Aromat in diesen Gruppen mit C₁-C₂₂-Alkyl, C₁-C₂₂-Alkoxy, Br, Cl, F und/oder CN substituiert sein kann, Br, Cl, F, CN oder Alkyfoxycarbonyl mit 2 bis 23 C-Atomen;
- k: ist 1 bis 25;
- n: ist 1 bis 200;
wobei R¹, R⁴, R⁵ und R⁸ sind, gleich oder verschieden, eine geradkettige oder verzweigte Alkyl- oder Alkoxygruppe mit 1 bis 22 C-Atomen. und die Summe aller n im Bereich von 3 bis 200 liegt, mit der Maßgabe, daß für k = 1, R¹, R⁴, R⁵ und R⁸ gleich oder verschieden eine geradkettige oder verzweigte Alkylkette mit 2 bis 22, vorzugsweise 3 bis 12 C-Atomen, wobei auch eine oder mehrere nicht benachbarte CH₂-Gruppen durch -O-, -S-, -SO₂-, -CO-O-, -O-CO- und/oder Phenylen ersetzt sein können, oder eine Arylgruppe oder Aryloxygruppe, wobei der Arylrest jeweils mit C₁-C₂₂-Alkyl, C₁-C₂₂-Alkoxy, Br, F, Cl, -CN und/oder NO₂ substituiert sein kann, bedeuten.

Bevorzugt sind Strukturen der Formeln (A) und (B), bei denen R², R³, R6, R⁷, R⁹ und R¹⁰ Wasserstoff bedeuten.

Weiterhin bevorzugt sind Polymere beschrieben durch die Formeln (A) und (B), bei denen R¹ gleich R⁴ und R⁵ gleich R⁸ ist.

Besonders bevorzugt sind Polymere beschrieben durch die Formeln (A) und (B), bei denen R², R³, R⁶, R⁷, R⁹ und R¹⁰ Wasserstoff bedeuten und bei denen R¹ gleich R⁴ und R⁵ gleich R⁸ sind und eine geradkettige oder verzweigte Alkoxygruppe mit 4 bis 7 C-Atomen bedeuten.

Bevorzugt ist der Index k eine natürliche Zahl im Bereich von 1 bis 13, besonders bevorzugt 1, 2 oder 3, ganz besonders bevorzugt 2 oder 3.

Vorzugsweise besteht ein erfindungsgemäßes Polymer aus Strukturelementen der allgemeinen Formel (AₖB)ₙ.

Dabei ist es bevorzugt, daß die Polymerkette nur ein Strukturelement der allgemeinen Formel (AₖB) mit einem bestimmten k enthält. Der Index n liegt dann vorzugsweise im Bereich von 5 bis 75.

Ebenso bevorzugt können die erfindungsgemäßen Polymere mehrere unterschiedliche Strukturelemente der Formel (AₖB) aufweisen. Hierbei ist anzumerken, daß das Strukturelement A nicht nur über die Reste R¹ bis R⁴ variiert werden kann, sondern auch über den Index k.

Bevorzugt sind in solchen Fällen statistische Copolymere, wie sie durch die Formel [(A¹ₖB¹)_{0,x}(A²ₖB²)_{0,y} .... (AⁿₖBⁿ)_{o,n}]ₘ mit 0,x + 0,y .... + 0,n = 1 und 3 ≤ m ≤ 200, wiedergegeben werden. Solche statistischen Copolymere enthalten vorzugsweise 2 bis 8 verschiedene Strukturelemente der Formel (AₖB).

Ebenso bevorzugt sind Blockcopolymere der Formel [(A¹ₖB¹)ₓ(A²ₖB²)_{y} - .... (AⁿₖBⁿ)ₙ]ₘ, wobei 3 ≤ m ≤ 200 gilt. Bevorzugt sind dabei Blockcopolymere, die zwei verschiedene Strukturelemente der Formel (AₖB) enthalten. x und y liegen vorzugsweise im Bereich von 1 bis 199, besonders bevorzugt von 2 bis 50, wobei x + y ≤ 200 ist.

Beim Vorhandensein von mehreren verschiedenen Strukturelementen der allgemeinen Formel (AₖB)ₙ kann jedes einzelne Element Werte für n im Bereich von 1 bis 200 annehmen, vorausgesetzt, daß die Summe aller n im Bereich von 3 bis 200, vorzugsweise im Bereich von 5 bis 75, liegt.

Vorteile der erfindungsgemäßen Polymeren sind unter anderem die niedrige Kristailisationstendenz und die guten Filmbildungseigenschaften.

Die erfindungsgemäßen Polymere zeichnen sich weiterhin durch eine beträchtliche Steigerung der Löslichkeit in organischen Solventien aus. Sie sind zudem strukturell einheitlich, trotz der löslichkeitsfördernden Seitengruppen sterisch nicht zusätzlich gehindert und weisen ein hohes Molekulargewicht auf.

Die Herstellung der erfindungsgemäßen Polymere ist nach verschiedenen Methoden möglich. Sie kann nach an sich literaturbekannten Methoden, wie sie in Standardwerken zur Organischen Synthese, z.B. Houben-Weyl, Methoden der Organischen Chemie, Georg-Thieme-Verlag, Stuttgart, beschrieben werden, erfolgen.
Die Herstellung erfolgt dabei unter Reaktionsbedingungen, die für die genannten Umsetzungen bekannt und geeignet sind. Dabei kann auch von an sich bekannten, hier nicht näher erwähnten Varianten Gebrauch gemacht werden.

Beispielsweise können Derivate des Benzols und des Stilbens oxidativ (z.B. mit FeCl₃, siehe u.a. P. Kovacic, N.B. Jones, Chem. Ber. **1987**, 87, 357; M.Wede, T. Abe, H. Awano, Macromolecules **1992**, 25, 5125) oder elektrochemisch (siehe z.B. N. Saito. T. Yamamoto, Polym. Bull. **1993**, 30, 285) polymerisiert werden.

Ebenso können die erfindungsgemäßen Polymeren aus Dihalogenaromaten unter Kupfer/Triphenylphosphin - (siehe z.B. G.W. Ebert, R.D. Rieke, J. Org. Chem. **1988**, 53, 4482) oder Nickel/Triphenylphosphin-Katalyse (siehe z.B. H. Matsumoto, S. Inaba, R.D. Rieke, J. Org. Chem. **1993**, 48, 849) synthetisiert werden.

Aromatische Distannane lassen sich, wie z.B. bei J.K. Stille, Angew. Chem., Int. Ed. Engl. **1986**, 25, 508 angegeben, unter Palladiumkatalyse polymerisieren.

Weiterhin können aromatische Dibromverbindungen in die Dilithio- oder Digrignardverbindungen überführt werden, die dann mit einer weiteren Dibromverbindung mittels CuCl₂ (siehe z.B. G. Wittig, G. Klar, Liebigs Ann. Chem. **1967**, 704, 91; H.A. Staab, F. Bunny, Chem. Ber. **1967**, 100, 293; T. Kaufmann, Angew. Chem. **1974**, 86, 321) oder durch Elektronentransfer ungesättigter 1,4-Dihalogenverbindungen (siehe z.B. S.K. Taylor, S.G. Bennet, K.J. Harz, L.K. Lashley, J. Org. Chem. **1981**, 46, 2190) polymerisiert werden.

Darüber hinaus lassen sich die erfindungsgemäßen Polymere durch Umsetzung der erwähnten Dibromverbindungen mit Nickelkatalysatoren in Gegenwart von 2,2'-Bipyridinen polymerisieren (siehe K. Chmil, U. Scherf, Makromol. Chem., Rapid Commun. **1993**, 14, 217).

Ebenfalls ist der Aufbau erfindungsgemäßer Polymere durch Knüpfung einer Doppelbindung möglich. Dies kann durch Eliminierung von Sauerstoff aus Dialdehyden (W.J. Feast, I.S. Millichamp, Polymer Comm. **1983**, 24, 102), Dehydrohalogenierung von Dihalogen-p-xylol-Derivaten (GB-A-1,092,824), durch Umsetzung von Ethylen mit den entsprechenden Dibromiden unter Palladiumkatalyse (A. Greiner, H. Martelock, A. Noll, N. Siegfried, W. Heitz, Polymer **1991**, 32, 1857), oder eine Wittig-Reaktion (H.-H. Hörhold, J. Opfermann, Faserforschung und Textiltechnik **1974**, 25, 1108) erreicht werden. Bei allen diesen Methoden treten jedoch unterschiedliche Mengen an Nebenprodukten auf und der Gehalt an Doppelbindungen im Polymer, bei denen die Polymerkette sich in trans-Position befindet, ist nicht immer 100 %.

Bevorzugt ist jedoch ein Verfahren zur Herstellung der erfindungsgemäßen Polymere, das dadurch gekennzeichnet ist, daß man eine oder mehrere Verbindungen der Formel (I) 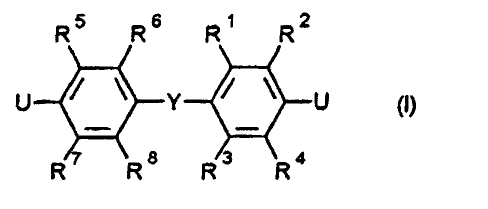 mit einer oder mehreren Verbindungen der Formel (II) und/oder (III) 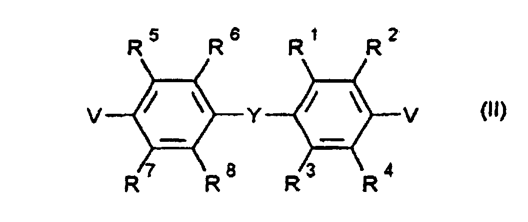 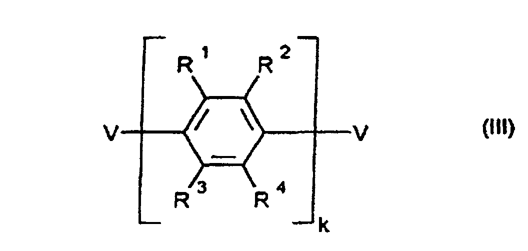 in einem inerten organischen Lösungsmittel oder Lösungsmittelgemisch mit mindestens einer Verbindung, die Palladium enthält, und gegebenenfalls einer Zusatzsubstanz umsetzt,
wobei die Symbole und Indizes in den Formeln (I) bis (III) folgende Bedeutungen haben:
- U und V: sind verschieden voneinander ein Halogen aus der Gruppe I, Br und Cl, vorzugsweise Br, oder BQ₁Q₂;
- Q₁, Q₂: sind gleich oder verschieden -OH, C₁-C₁₀-Alkoxy, C₁-C₁₀-Alkyl, Phenyl, das gegebenenfalls durch C₁-C₁₀-Alkyl, C₁-C₁₀-Alkoxy oder Halogen substituiert sein kann, oder Halogen oder Q₁ und Q₂ zusammen bilden eine C₁-C₄-Alkylendioxy-Gruppe, eine Methylengruppe, die gegebenenfalls durch eine oder zwei C₁-C₄-Alkylgruppen substituiert sein kann, oder Q₁ und Q₂ und das Boratom zusammen sind Teil einer Boroxinrings der Formel (IV) 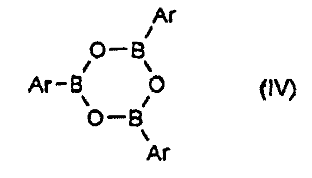
- Ar: ist ein aromatischer Rest der Formel (I), (II) oder (III);
- Y: ist gleich oder verschieden -CR⁹=CR¹⁰-, R¹, R², R³, R⁴, R⁵, R⁶, R⁷, R⁸, R⁹, R¹⁰, sind in den einzelnen Strukturelementen unabhängig voneinander gleich oder verschieden, H, eine geradkettige oder verzweigte Alkylkette mit 1 bis 22 C-Atomen, wobei eine oder mehrere nicht benachbarte CH₂-Gruppen auch durch -O-, -S-, -SO₂-, -COO-, -OOC- und/oder Phenylen, vorzugsweise 1,4-Phenylen, ersetzt sein können, Aryl- oder Aryloxygruppen, vorzugsweise mit 4 bis 14 C-Atomen, wobei der Aromat in diesen Gruppen mit C₁-C₂₂-Alkyl, C₁-C₂₂-Alkoxy, Br, Cl, F, CN, und/oder NO₂ substituiert sein kann, Br, Cl, F, CN, NO₂ oder Alkyloxycarbonyl mit 2 bis 23 C-Atomen;
- k: ist 1 bis 25, bevorzugt 1 bis 13, besonders bevorzugt 1, 2 oder 3, insbesondere 2 oder 3.

Vorteilhafterweise werden annähernd äquimolare Mengen des Boronsäure(esters) und der Halogenverbindung umgesetzt. Bevorzugt ist es, den Boronsäure(ester) in einem 1,001 bis 1,1, besonders bevorzugt 1,025fachen Überschuß einzusetzen.

Die Umsetzung erfolgt im allgemeinen bei einer Temperatur im Bereich von 0 bis 150°C, vorzugsweise bei 20 bis 100°C und besonders bevorzugt bei 70 bis 90°C. Die Reaktionsdauer liegt im allgemeinen bei einer Stunde bis üblicherweise 3 bis 5 Tagen.

Bevorzugte Lösungsmittel sind Gemische, deren Komponenten unter den Reaktionsbedingungen mischbar oder nicht mischbar, vorzugsweise nicht mischbar, sind. Bevorzugt für die erste Komponente ist ein polar protisches Lösungsmittel, wie Wasser. Bevorzugt als weitere Komponente sind N,N-Dialkylamide, wie Dimethylformamid (DMF), N-Methyl-2-pyrrolidon, Ether, wie Tetrahydrofuran (THF), aromatische Kohlenwasserstoffe, wie Toluol, und Gemische der angeführten Lösungsmittel. Besonders bevorzugt ist eine binäre Mischung aus THF und Wasser, insbesondere im Verhältnis 1 : 1.

Verbindungen, die Palladium enthalten, zeigen katalytische Aktivität für die Polymerisationsreaktion. Bevorzugt sind Verbindungen, die Palladium in der Oxidationsstufe O enthalten oder unter den Reaktionsbedingungen Palladium(O)-Spezies bilden, besonders bevorzugt ist Tetrakis-(triphenylphosphin)-palladium (O), das direkt eingesetzt werden kann. Im allgemeinen wird eine Konzentration von 1 mol% Katalysator pro Mol der eingesetzten Monomermenge verwendet. Als Zusatzsubstanz werden im allgemeinen schwache Basen verwendet, bevorzugt ist Natriumhydrogencarbonat in einer Konzentration von 1 mol/l, bezogen auf die eingesetzte Menge Wasser.

Zur Herstellung von statistischen Copolymeren können beispielsweise unterschiedliche Verbindungen der Formel (I) und (II) oder (I) und (III) oder (I) und (II) und (III) gemeinsam polymerisiert werden.

Auch verschiedene Bromderivate (U bzw. V ist Br) können, z.B. wie oben angegeben unter Ni°-Katalyse, zu statistischen Copolymeren gekuppelt werden.

Zur Herstellung von Blockcopolymeren wird beispielsweise eine Halogenkomponente mit einem so großen Überschuß einer Boronsäure(ester)komponente umgesetzt, daß Oligomere einer definierten Länge mit endständigen Boronsäure(ester)-Gruppen entstehen. Ein zweiter Block wird durch Umsetzung einer Boronsäure(ester)-Komponente mit einem entsprechenden Überschuß einer Halogenkomponente erzeugt; die Oligomeren dieses zweiten Blocks haben endständige Halogenfunktionen. Alternativ können derartige terminierte Oligomere auch durch Borierung von Brom-termierten Oligomeren aufgebaut werden. Umsetzung der beiden Blöcke im Verhältnis 1:1 führt zu erfindungsgemäßen Blockcopolymeren.

Durch den Einbau von Monomereinheiten der Formel (V), 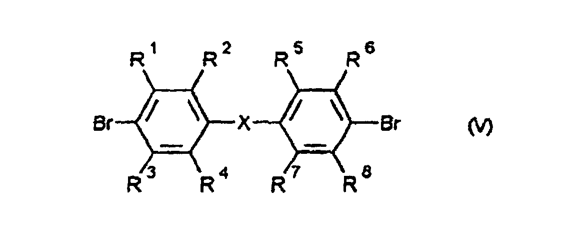 in der die Substituenten R¹ bis R⁸ die oben angegebene Bedeutung haben und X eine gesättigte Kohlenwasserstoffkette -(CH₂)ₙ- der Länge n = 1 bis 10 ist, wobei eine oder mehrere nicht benachbarte CH₂-Gruppen auch durch -O-, -S-, -SO₂-, -COO-, -OOC- und/oder Phenyl ersetzt sein können, ist eine definierte Unterbrechung der Konjugation innerhalb des Polymerrückgrates möglich. Derartige Stellen unterbinden die Möglichkeit der Diffusion der angeregten Molekülzustände und erhöhen die Quantenausbeute der entsprechenden Elektrolumineszenzvorrichtung.

Bisher konnten derartige Unterbrechungen der Konjugation nur in undefinierten Mengen und Abständen eingeführt werden (A.B. Holmes et al., Synth. Metals **1993**, 55, 4031).

Eine weitere Möglichkeit der Unterbrechung der Konjugation entlang der Polymer Hauptkette besteht im definierten Einsatz von Monomeren, die eine 1,3-Dibrom-Substitution aufweisen. Im resultierenden Polymer tritt ein entsprechender Knick auf, der die Konjugation effektiv unterbindet.

Dieses Monomer wird an Stelle des entsprechenden Stilbendibromid-Monomers so eingesetzt, daß das ungefähr äquimolare Verhältnis von Dibromid zu Diboronsäure nicht verändert wird.

Darüber hinaus ist auch beispielsweise durch Verwendung von Monomerbausteinen der Formel (VI), 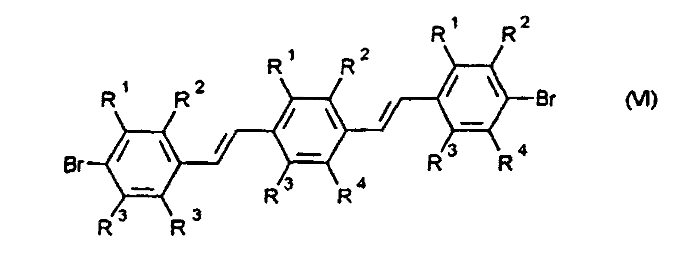 in denen die Substituenten R¹ bis R⁴ die oben angegebene Bedeutung haben, der Einbau von einzelnen p-Phenylen-vinylen-Einheiten möglich.

Gegenstand der Erfindung sind daher auch Polymere die neben mindestens einem Strukturelement der Formel (AₖB)ₙ ein oder mehrere Strukturelemente der Formel (VII) und/oder (VIII) enthalten, 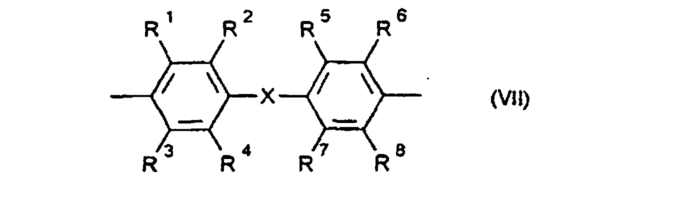 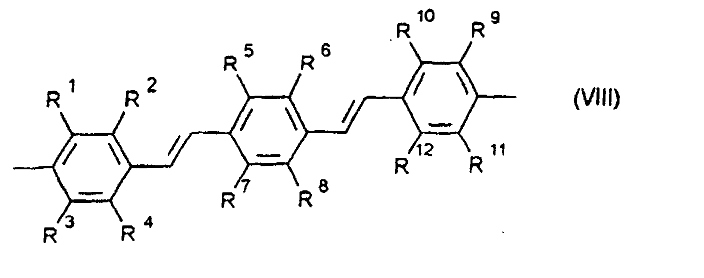 wobei die Symbole R¹ bis R¹² und X die oben angegebenen Bedeutungen haben.

Die Aufarbeitung erfolgt nach den bekannten, dem Fachmann geläufigen Methoden. Beispielsweise kann man die Reaktionsmischung in Methanol gießen, filtrieren, mit Wasser waschen, extrahieren und das erhaltene Rohprodukt durch Umfäffen weiter reinigen.

Die Herstellung der Monomerbausteine der Formeln (I) bis (III) kann nach an sich literaturbekannten Methoden, wie sie in Standardwerken zur Organischen Synthese, z.B. Houben-Weyl, Methoden der Organischen Chemie, Georg-Thieme-Verlag, Stuttgart, beschrieben werden, erfolgen. Die Herstellung erfolgt unter Reaktionsbedingungen, die für die genannten Umsetzungen bekannt und geeignet sind. Dabei kann auch von an sich bekannten, hier nicht näher erwähnten Varianten Gebrauch gemacht werden.

Methoden zur Synthese substituierter 1,4-Dibrombenzole oder weiterer 1,4-Dihalogenverbindungen sind als Standardreaktionen bekannt (siehe z.B. J. March, Advanced Organic Chemistry, 4. Aufl., S. 531 - 534, John Wiley & Sons, New York 1992.

1,4-Dibrom-alkyl-benzole sind beispielsweise durch Alkylierung von 1,4-Dihalogen-benzolen durch Grignard-Reaktion und anschließende regioselektive Bromierung in 2,5-Stellung herstellbar.

1,4-Dibrom(pseudo)halogenverbindungen sind beispielsweise aus den entsprechenden Dibromiden durch Austausch mit beispielsweise Cyanogruppen zugänglich (M. Rehahn, A.-D. Schlüter, W.J. Feast, Synthesis **386**, 1988).

Entsprechend sind auch zahlreiche Wege zur Synthese der Oligo-p-phenylenund Stilben-Derivate anwendbar.

Oligo-p-phenylen lassen sich beispielsweise nach den oben erwähnten Methoden aus den entsprechenden Monomeren aufbauen.

Stilbenderivate lassen sich beispielsweise nach den in Houben-Weyl, Methoden der Organischen Chemie, Georg-Thieme-Verlag, Stuttgart, beschriebenen Methoden synthetisieren (z.B. Wittig Reaktion, Knoevenagel Reaktion, Heck-Reaktion).

Bevorzugt ist ein Syntheseweg, der am Beispiel der besonderen bevorzugten bisalkoxysubstituierten 1,4-Dibrombenzole in Schema 1 dargestellt ist.

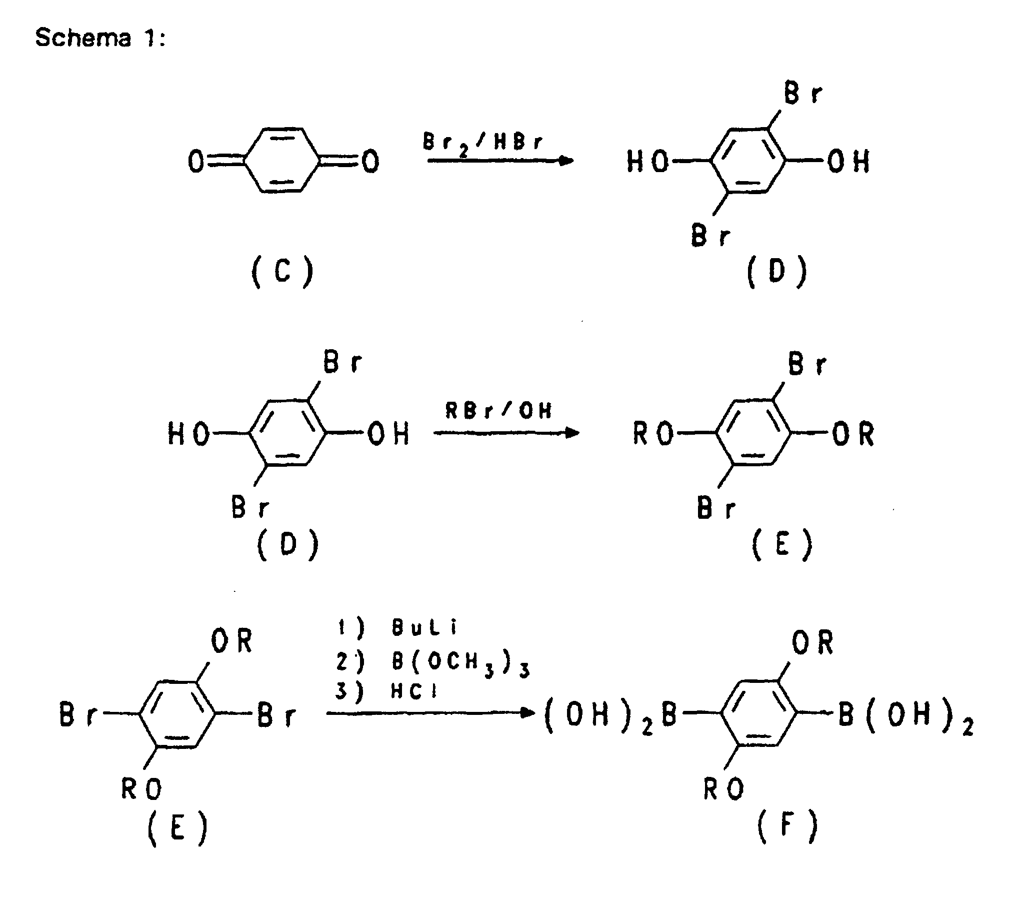

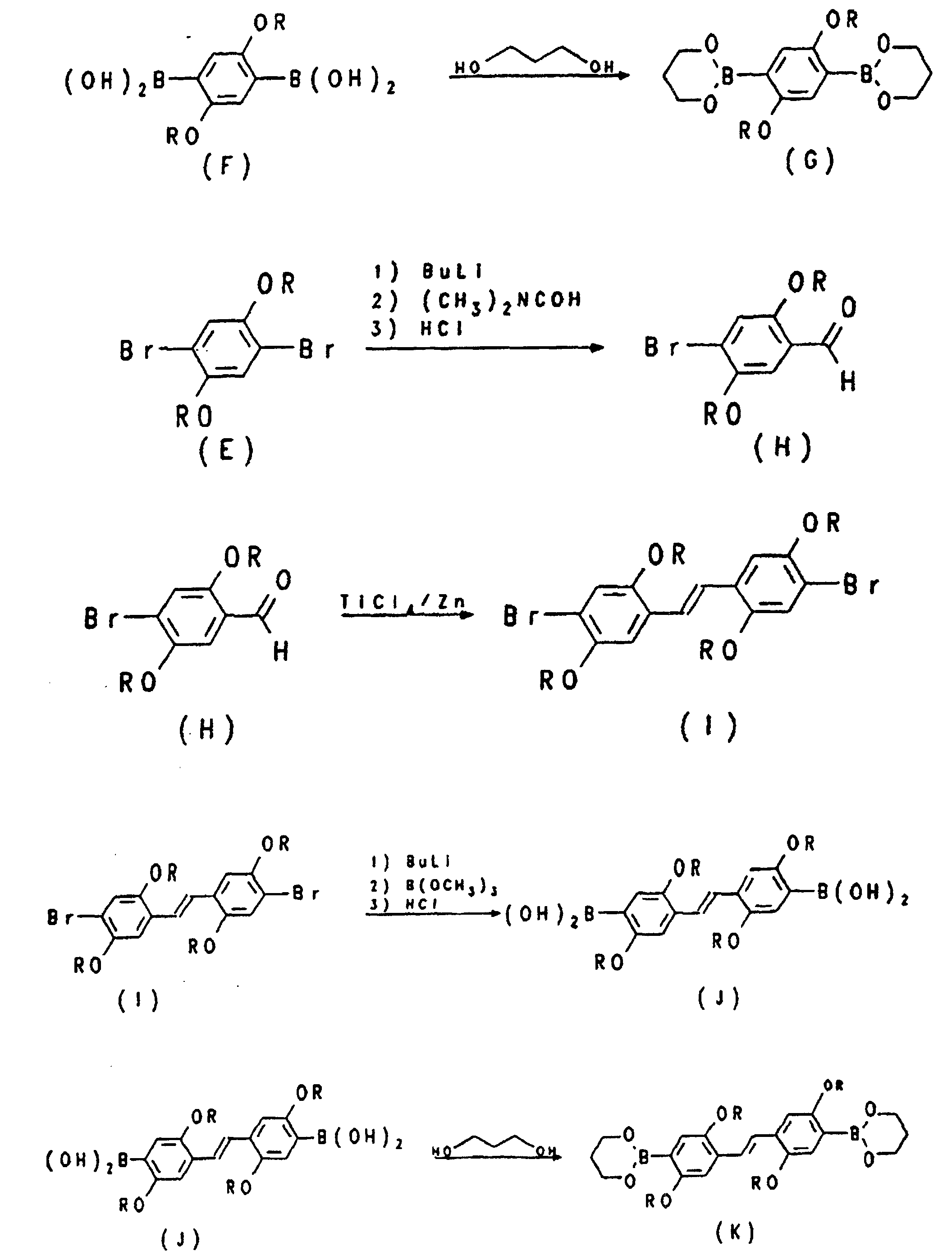

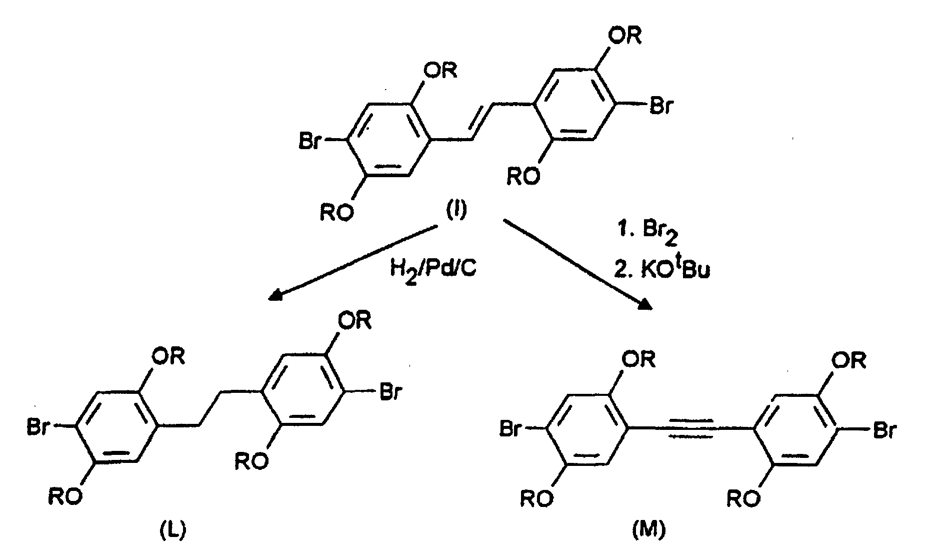

Nach Schema 1 wird p-Benzochinon (C) in wäßriger HBr-Lösung mit Br₂ reduktiv zum Dibromhydrochinon (D) umgesetzt und mit entsprechenden Alkylbromiden verethert (E). Um statt der auf diese Weise erhaltenen Alkoxysubstituenten Verbindungen mit Alkylsubstituenten zu erhalten, kann ausgehend von 1,4-Dichlorbenzol in einer Grignard-Reaktion ein 1,4-dialkylierter Aromat erhalten werden, der durch anschließende regioselektive Bromierung zu einem zu (E) analogen Dibromid umgesetzt wird. Diese Produkte lassen sich nach einem Halogen-Metall-Austausch mit Trimethylborat verestern und zur entsprechenden Diboronsäure (F) verseifen. Diese wird anschließend mit 1,3-Propandiol zum cyclischen Diester (G) erneut verestert.

Ausgehend vom Dibromid (E) ist auch das Stilbenderivat-Monomer zugänglich. Dazu wird zunächst in einer Bouveault-Reaktion formyliert und das entstandene Benzaldehydderivat (H) in einer McMurry-Reaktion zum Dibromstilbenderivat (I) gekuppelt. Hieraus ist nach Borierung (J) und Veresterung wiederum der cyclische Diboronsäureester (K) zugänglich.

Ebenso lassen sich aus dem Dibromstilbenderivat (I) durch Hydrierung, beispielsweise mit H₂/Pd/C, oder Eliminierung, beispielsweise durch Bromierung und anschließende Umsetzung mit einer starken Base, wie KO^{t}Bu, 1,2-Diphenylethane (L) (Y = -CHR¹¹-CHR¹²-) bzw. Tolane (M) (Y = -C≡C-) herstellen.

Die nach diesem Verfahren hergestellten monomeren Spezies eignen sich hervorragend als Ausgangsprodukte zur Herstellung der erfindungsgemäßen Polymere.

Die Dibromide (E) und (I) können aber ebensogut nach literaturbekannten Methoden beispielsweise zu Distannanen (J.K. Stille, Angew. Chem. Int. Ed. Engl. **1986**, 25, 508) umgesetzt werden, die ebenfalls Ausgangsverbindungen für die erfindungsgemäßen Polymeren sein können.

Ein weiterer Gegenstand der Erfindung ist die Verwendung der erfindungsgemäßen Polymeren als Elektrolumineszenzmaterialien, d.h. als aktive Schicht in einer Elektrotumineszenzvorrichtung. Als aktive Schicht im Sinne der Erfindung gelten Elektrolumineszenzmaterialien, die befähigt sind, bei Anlegen eines elektrischen Feldes Licht abzustrahlen (lichtemittierende Schicht), sowie Materialien, welche die Injektion und/oder den Transport der positiven und/oder negativen Ladungen verbessern (Ladungsinjektionsschichten und Ladungstransportschichten).

Gegenstand der Erfindung ist daher auch ein Elektrolumineszenzmaterial, enthaltend oder vorzugsweise im wesentlichen bestehend aus einem oder mehreren, vorzugsweise einem erfindungsgemäßen Polymer.

Dieses Elektrolumineszenzmaterial ist vorzugsweise ein lichtemittierendes Material, ein Ladungstransportmaterial, insbesondere ein Elektronen- oder Lochtransportmaterial, oder ein Ladungsinjektionsmaterial, insbesondere ein Elektronen- oder Lochinjektionsmaterial.

Gegenstand der Erfindung ist weiterhin eine Elektrolumineszenzvorrichtung mit einer oder mehreren aktiven Schichten, wobei mindestens eine dieser aktiven Schichten mindestens ein erfindungsgemäßes Polymer enthält. Die aktive Schicht kann beispielsweise eine lichtemittierende Schicht und/oder eine Transportschicht und/oder eine Ladungsinjektionsschicht sein.

Der allgemeine Aufbau solcher Elektrolumineszenzvorrichtungen ist beispielsweise in der US-A-4,539,507 und der US-A-5,151,629 beschrieben. Polymere enthaltende Elektrolumineszenzvorrichtungen sind beispielsweise in der WO 90/13148 und der EP-A O 443861 beschrieben.

Sie enthalten üblicherweise eine oder mehrere elektrolumineszierende Schichten zwischen einer Kathode und einer Anode, wobei mindestens eine der Elektroden transparent ist. Zusätzlich können zwischen der oder den elektrolumineszierenden Schichten und der Kathode eine oder mehrere Elektroneninjektions- und/oder Elektronentransportschichten eingebracht sein und/oder zwischen der oder den elektrolumineszierenden Schichten und der Anode eine oder mehrere Lochinjektions- und/oder Lochtransportschichten eingebracht sein. Als Kathode können verschiedene Metalle, z.B. Ca, Mg, Al, Mg/Al, dienen. Als Anode können, Metalle oder Verbindungen, z.B. Au oder ITO (Indiumoxid/Zinnoxid), auf einem transparenten Substrat, z.B. aus Glas oder einem transparenten Polymer, dienen.

Im Betrieb wird die Kathode auf negatives Potential gegenüber der Anode gesetzt. Dabei werden Elektronen von der Kathode in eine Elektroneninjektionsschicht/Elektronentransportschicht bzw. direkt in eine lichtemittierende Schicht injiziert. Gleichzeitig werden Löcher von der Anode in eine Lochinjektionsschicht/Lochtransportschicht bzw. direkt in eine lichtemittierende Schicht injiziert.

Die injizierten Ladungsträger bewegen sich unter dem Einfluß der angelegten Spannung durch die aktiven Schichten aufeinander zu. Dies führt an der Grenzfläche zwischen Ladungstransportschicht und lichtemittierender Schicht bzw. innerhalb der lichtemittierenden Schicht zu Elektronen/Loch-Paaren, die unter Aussendung von Licht rekombinieren.

Die Farbe des emittierten Lichtes kann durch die als lichtemittierende Schicht verwendete Verbindung variiert werden.

Elektrolumineszenzvorrichtungen finden Anwendung z.B. als selbstleuchtende Anzeigeelemente, wie Kontrollampen, alphanumerische Displays, Hinweisschilder, und in optoelektronischen Kopplern.

Die in der Beschreibung aufgeführten Literaturstellen sollen als Bestandteil der Beschreibung gelten.

Die Erfindung wird im folgenden anhand von Ausführungsbeispielen näher erläutert, ohne dadurch beschränkt zu werden.

### Beispiel 1

### Poly(2,2',2",5,5',5"-hexa-(i-pentyloxy)-p-terphenyl-4,4"-ylen-vinylen)

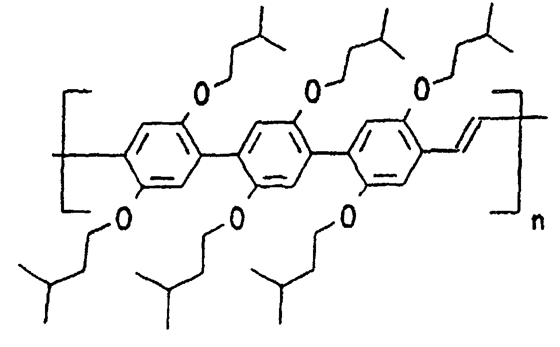

Summenformel: C₅₀H₇₄O₆
Molgewicht der Wiederholungseinheit: 770 g/mol
Schmelzpunkt: 210 °C

### Synthesebeschreibung

1,142 g (1,67 mmol) 4,4'-Dibrom-2,2',5,5'-tetra-iso-pentyloxy-trans-stilben, 0,700 g (1,67 mmol) 2,5-Di-iso-pentyloxy-1,4-benzol-diboronsäure-propan-1,3-diol-diester und 2,11 g (20 mmol) Natriumhydrogencarbonat werden in einen Schlenkkolben eingewogen, dieser mit einem Intensivkühler verbunden und der Aufbau durch dreimaliges Evakuieren (10⁻¹ mbar) und vorsichtiges Belüften mit Argon unter Schutzgas gesetzt. Im Argongegenstrom werden nun 20 ml absolutes Tetrahydrofuran und 20 ml entgastes (dreistündiger Stickstoffstrom bei 80°C), deionisiertes Wasser eingespritzt. Nachdem sich alle festen Bestandteile unter Rühren gelöst haben, wird eine Lösung von 20 mg (1,5*10⁻⁵ mol) Palladiumkatalysator (Pd(PPh₃)₄ in wenig absolutem Tetrahydrofuran zugespritzt und der Reaktionsansatz unter sehr starkem Rühren für 72 Stunden auf 80°C erhitzt. Zum Schutz des lichtempfindlichen Katalysators sollte in dieser Zeit direkte Lichteinstrahlung vermieden werden.

Nach Abkühlung auf Raumtemperatur wird der Ansatz unter Ar-Schutzgas in Methanol eingegossen (Volumenverhältnis 1 : 5). Der Niederschlag wird filtriert, mit Wasser gewaschen, in Chloroform aufgenommen und erneut filtriert. Das Filtrat wird eingeengt, in Benzol aufgenommen und nach Filtration durch einen 0,2 µm-Filter (Millipore) gefriergetrocknet.

### Beispiel 2

### Poly(2,2',5,5'-tetra-(i-pentyloxy)-p-biphenyl-ylen-vinylen)

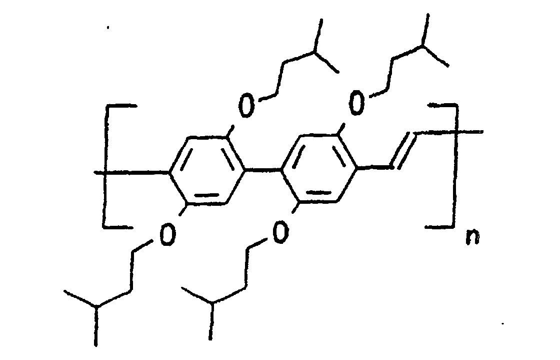

Summenformel: C₃₄H₅₀O₄
Molgewicht der Wiederholungseinheit: 522 g/mol
Schmelzpunkt: 220 °C

### Synthesebeschreibung

413,0 mg (0,6 mmol) 4,4'-Dibrom-2,2',5,5'-tetra-iso-pentyloxy-trans-stilben, 418,6 mg (0,6 mmol) 2,2',5,5'-tetra-iso-pentyloxy-4,4'-trans-stilbendiboronsäurepropylester und 1,05 g (10 mmol) Natriumhydrogencarbonat werden in einen Schlenkkolben eingewogen, dieser mit einem Intensivkühler verbunden und der Aufbau durch dreimaliges Evakuieren (10⁻¹ mbar) und vorsichtiges Belüften mit Argon unter Schutzgas gesetzt. Im Argongegenstrom werden nun 10 ml absolutes Tetrahydrofuran und 10 ml entgastes, deionisiertes Wasser eingespritzt. Nachdem sich alle festen Bestandteile unter Rühren gelöst haben, wird eine Lösung von 7,2 mg (6,2*10⁻⁶ mol) Palladiumkatalysator (Pd(PPh₃)₄ in wenig absolutem Tetrahydrofuran zugespritzt und der Reaktionsansatz unter sehr starkem Rühren für 72 Stunden auf 80°C erhitzt. Zum Schutz des lichtempfindlichen Katalysators sollte in dieser Zeit direkte Lichteinstrahlung vermieden werden.

Nach Abkühlung auf Raumtemperatur wird der Ansatz unter Ar-Schutzgas in Methanol eingegossen (Volumenverhältnis 1 : 5). Der Niederschlag wird filtriert, mit Wasser gewaschen, in Chloroform aufgenommen und erneut filtriert. Das Filtrat wird eingeengt, in Benzol aufgenommen und nach Filtration durch einen 0,2 µm-Filter (Millipore) gefriergetrocknet.

### Beispiel 3

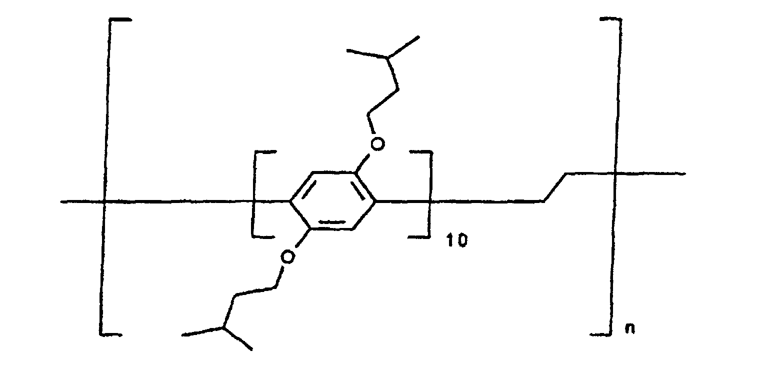

Summenformel: C₁₆₂H₂₄₄O₂₀
Molgewicht der Wiederholungseinheit: 2508 g/mol
Schmelzpunkt: 170°C

### Synthesebeschreibung:

0,3902 g (0,952 mmol) 1.4-Dibrom-2,5-di-iso-pentoxybenzol, 0,1638 g (0,239 mmol) 1,2-Di-(4-brom-2,5-di-iso-pentoxy-phenyl)ethan, 0,51 g (1,220 mmol) 1,4-Di-iso-pentoxy-2,5-phenyldiboronsäure-propandiol-diester und 1,26 g Natriumhydrogencarbonat werden in einen Schlenkkolben eingewogen, dieser mit einem Intensivkühler verbunden und der Aufbau durch dreimaliges Evakuieren (10⁻¹ mbar) und vorsichtiges Belüften mit Argon unter Schutzgas gesetzt. Im Argongegenstrom werden nun 10 ml absolutes Tetrahydrofuran und 10 ml entgastes, deionisiertes Wasser eingespritzt. Nachdem sich alle festen Bestandteile unter Rühren gelöst haben, wird eine Lösung von 15 mg (1,3*10⁻⁵ mol) Palladiumkatalysator (Pd(PPh₃)₄ in wenig absolutem Tetrahydrofuran zugespritzt und der Reaktionsansatz unter sehr starkem Rühren für 72 Stunden auf 80°C erhitzt. Zum Schutz des lichtempfindlichen Katalysators sollte in dieser Zeit direkte Lichteinstrahlung vermieden werden.

Nach Abkühlung auf Raumtemperatur wird der Ansatz unter Ar-Schutzgas in Methanol eingegossen (Votumenverhältnis 1 : 5). Der Niederschlag wird filtriert, mit Wasser gewaschen, in Chloroform aufgenommen und erneut filtriert. Das Filtrat wird eingeengt, in Benzol aufgenommen und nach Filtration durch einen 0,2 µm-Filter (Millipore) gefriergetrocknet.

### Beispiel 4

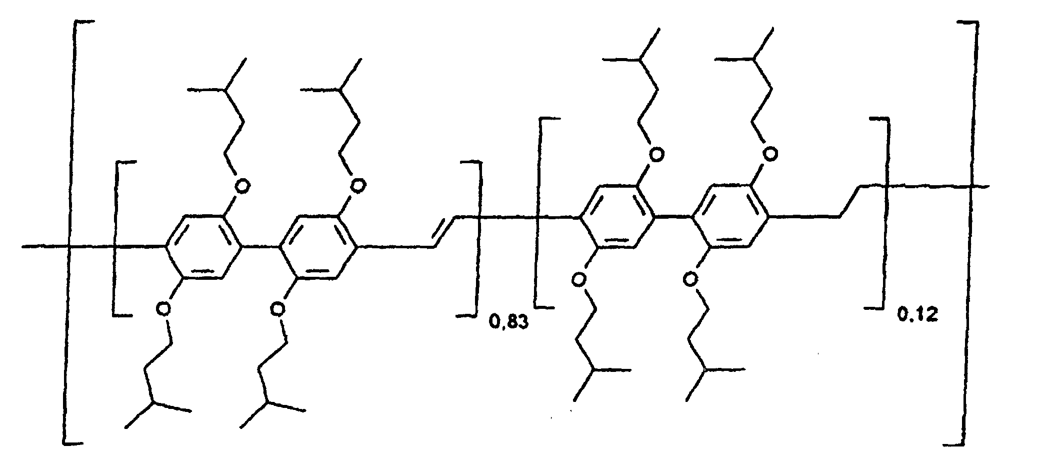

Summenformel: C₂₀₄H₃₀₂O₂₄
Molgewicht der Wiederholungseinheit: 3134 g/mol
Schmelzpunkt: 210°C

### Synthesebeschreibung:

0,2991 g (0,484 mmol) 4,4'-Dibrom-2.2'.5,5'-tetra-isopentoxy-transstilben, 0,200 g (0.292 mmol) 1,2-Di-(4-brom-2,5-di-iso-pentoxy-phenyl)ethan, 0,4958 g (0,716 mmol) 2,2',5,5'-tetra-iso-pentoxy-4,4'-trans-stilbendiboronsäurepropylester und 0,84 g Natriumhydrogencarbonat werden in einen Schlenkkolben eingewogen, dieser mit einem Intensivkühler verbunden und der Aufbau durch dreimaliges Evakuieren (10⁻¹ mbar) und vorsichtiges Belüften mit Argon unter Schutzgas gesetzt. Im Argongegenstrom werden nun 10 ml absolutes Tetrahydrofuran und 10 ml entgastes, deionisiertes Wasser eingespritzt. Nachdem sich alle festen Bestandteile unter Rühren gelöst haben, wird eine Lösung von 10 mg (0,9*10⁻⁵ mol) Palladiumkatalysator (Pd(PPh₃)₄ in wenig absolutem Tetrahydrofuran zugespritzt und der Reaktionsansatz unter sehr starkem Rühren für 72 Stunden auf 80°C erhitzt. Zum Schutz des lichtempfindlichen Katalysators sollte in dieser Zeit direkte Lichteinstrahlung vermieden werden.

Nach Abkühlung auf Raumtemperatur wird der Ansatz unter Ar-Schutzgas in Methanol eingegossen (Volumenverhältnis 1 : 5). Der Niederschlag wird filtriert, mit Wasser gewaschen, in Chloroform aufgenommen und erneut filtriert. Das Filtrat wird eingeengt, in Benzol aufgenommen und nach Filtration durch einen 0,2 µm-Filter (Millipore) gefriergetrocknet.

### Beispiel 5

### Verwendung als Elektrolumineszenzmaterial

Ein Quarzglasträger wird zunächst mit Aceton abgerieben, 15 Minuten in Methylenchlorid im Ultraschallbad vorgereinigt, 30 Minuten in einer Reaktionslösung bestehend aus 10 % Wasserstoffperoxid (30 %ig), 40 % wäßrig, konz. Ammoniaklösung und 50 % Milli-Q-Wasser (entionisiertes Wasser mit einer Leitfähigkeit von 0,5 µS/cm) behandelt und anschließend 10 Minuten in einem Strom von Milli-Q-Wasser gewaschen. Der auf diese Weise gereinigte Glasträger wird 5 Minuten bei 1 mbar im Argon-Plasma behandelt und anschließend 30 Minuten in einer 30 %igen Lösung von Hexamethyldisilazan in Chloroform hydrophobisiert. Bei 2x10⁻⁵ mbar werden 2 mm breite Streifen von zunächst Chrom (4 nm) und anschließend Gold (17 nm) aufgedampft.

Der Polymerfilm wird durch Schleuderbeschichtung aufgebracht. Dazu werden einige Tropfen einer 3 %igen Polymerlösung (Polymer aus Beispiel 1) in Toluol auf den Glasträger gebracht und dieser eine Minute lang mit 2000 U/min rotiert. Nach Trocknung des Substrates kann der 100 nm dicke homogene Polymerfilm weiter bearbeitet werden.

Anschließend wird bei 2x10⁻⁵ mbar quer zur Goldbeschichtung Al in 2 mm breiten Streifen aufgedampft. Die so erhaltene Vorrichtung Au/Polymer/Al wird in einen Probenhalter gegeben und die Elektroden mit einer Stromquelle verbunden, wobei die Au-Streifen positiv und die Al-Streifen negativ gepolt werden. Beim Anlegen einer Feldstärke von 15 x 10⁷ V/m, wird an dem entsprechenden Matrixelement eine intensive, homogene, blaue Fluoreszenz beobachtet. Das Elektrolumineszenzspektrum entspricht im wesentlichem dem Photolumineszenzspektrum. Die externe Quantenausbeute liegt dabei im Bereich von 0,1 %.

### Beispiel 6

Ein mit einem 2 mm breiten Streifen von transparenten, leitenden Indium-Zinn-Oxid (ITO) beschichteter Glasträger wird durch Reiben mit Aceton und 15 Minuten Ultraschall in Methylenchlorid gereinigt.

Durch Schleuderbeschichtung werden nacheinander jeweils 100 mm dicke Schichten von
- Poly-(vinylcarbazol) (PVK) in Chloroform
- dem Polymer aus Beispiel 3 in Toluol
- 2-(4-Biphenylyl)-5-(4-tert.-butyl-phenyl)-(1,3,4)oxadiazol (PBD) 25 %ig in Polystyrol in Aceton
aufgebracht.

Anschließend wird bei 2x10⁵ mbar quer zu dem ITO-Streifen ein ca. in 1 mm breiten Streifen aufgedampft. Die so erhaltene Vorrichtung Glas/ITO/PVK/Polymer/PBD in PS/Ca wird unter Argonatmosphäre in einen Probenhalter gegeben und die Elektroden mit einer Stromquelle verbunden, wobei die ITO-Streifen positiv und die Ca-Streifen negativ gepolt werden. Beim Anlegen einer Spannung von 16 V, wird an dem entsprechenden Matrixelement eine intensive, homogene, blaue Fluoreszenz beobachtet. Das Elektrolumineszenzspektrum entspricht im wesentlichem dem Photolumineszenzspektrum. Die interne Quantenausbeute liegt dabei im Bereich von 1,0 %.

## Patentansprüche

1. Ein Oligo-p-phenyleneinheiten enthaltendes Polymer, das mindestens ein Strukturelement der allgemeinen Formel (AₖB)ₙ enthält, wobei die Symbole und Indizes folgende Bedeutungen haben:
A ist gleich oder verschieden 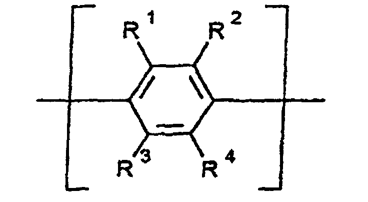
B ist gleich oder verschieden 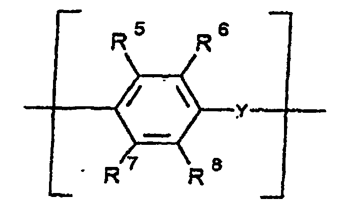
Y ist gleich oder verschieden -CR⁹=CR¹⁰-;
R², R³, R⁶, R⁷, R⁹, R¹⁰ sind in den einzelnen Strukturelementen unabhängig voneinander gleich oder verschieden, H, eine geradkettige oder verzweigte Alkylkette mit 1 bis 22 C-Atomen, wobei eine oder mehrere nicht benachbarte CH₂-Gruppen auch durch -O-, -S-, -SO₂-, -COO-, -OOC- und/oder Phenylen ersetzt sein können, Aryl- oder Aryloxygruppen, wobei der Aromat in diesen Gruppen mit C₁-C₂₂-Alkyl, C₁-C₂₂-Alkoxy, Br, Cl, F und/oder CN substituiert sein kann, Br, Cl, F, CN oder Alkyloxycarbonyl mit 2 bis 23 C-Atomen;
R¹, R⁴, R⁵ und R⁸ gleich oder verschieden eine geradkettige oder verzweigte Alkyloder Alkoxygruppe mit 1 bis 22 C-Atomen bedeuten
k ist 1 bis 25;
n ist 3 bis 200.

2. Polymer gemäß Anspruch 1, **dadurch gekennzeichnet, daß** in den Formeln (A) und (B) R², R³, R⁶, R⁷, R⁹, R¹⁰ Wasserstoff bedeuten.

3. Polymer gemäß mindestens einem der Ansprüche 1 oder 2, bestehend aus Strukturelementen der allgemeinen Formel (AₖB)ₙ.

4. Polymer gemäß Anspruch 3, **dadurch gekennzeichnet, daß** es ein Homopolymer, ein statistisches Copolymer oder ein Blockcopolymer ist.

5. Polymer gemäß mindestens einem der Ansprüche 1 oder 2, **dadurch gekennzeichnet, daß** es zusätzlich zu mindestens einem Strukturelement der Formel (AₖB)ₙ ein oder mehrere Strukturelemente der Formel (VII) enthält, 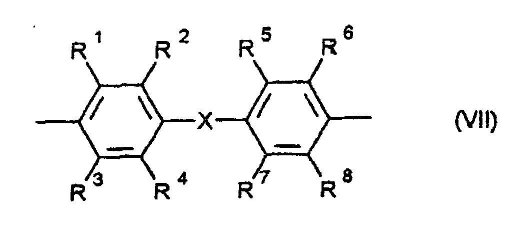 wobei R¹ bis R⁸ die bei dem Strukturelemen (AₖB)ₙ angegebenen Bedeutungen haben und X eine gesättigte Kohlenwasserstoffkette -(CH₂)ₙ- mit n = 1 bis 10 ist, wobei eine oder mehrere nicht benachbarte CH₂-Gruppen auch durch -O-, -S-, -SO₂-, -COO-, -OOC- und/oder Phenyl ersetzt sein können.

6. Polymer gemäß mindestens einem der Ansprüche 1 oder 2, **dadurch gekennzeichnet, daß** es neben mindestens einem Strukturelement der Formel (AₖB)ₙ ein oder mehrere Strukturelemente der Formel (VIII) enthält 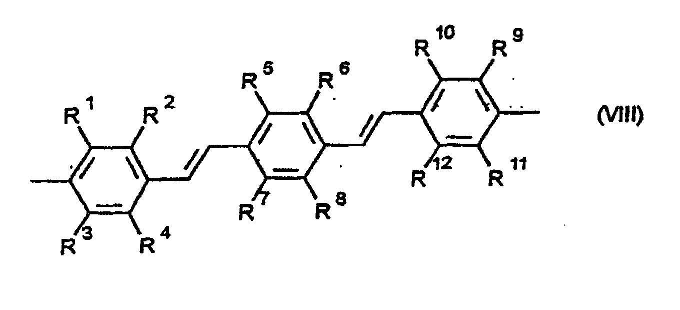 enthält, wobei R¹ bis R⁴ die bei dem Strukturelement (AₖB)ₙ angegebenen Bedeutungen haben.

7. Verwendung eines Polymers gemäß mindestens einem der Ansprüche 1 bis 6 als Elektrolumineszenzmaterial.

8. Elektrolumineszenzmaterial, enthaltend ein oder mehrere Polymere gemäß mindestens einem der Ansprüche 1 bis 6.

9. Elektrolumineszenzvorrichtung, enthaltend eine oder mehrere aktive Schichten, **dadurch gekennzeichnet, daß** mindestens eine dieser aktiven Schichten ein oder mehrere Polymere gemäß mindestens einem der Ansprüche 1 bis 6 enthält.

## Claims

1. A polymer which comprises oligo-p-phenylene units and comprises at least one structural element of the formula (AₖB)ₙ, where the symbols and indices have the following meanings:
A are identical or different units 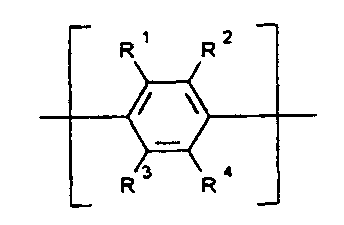
B are identical or different units 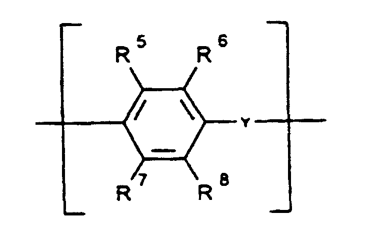
Y are identical or different and are each -CR⁹=CR¹⁰-;
R², R³, R⁶, R⁷, R⁹, R¹⁰ are, independently of one another, identical or different in the individual structural elements and are each H, a straight-chain or branched alkyl group having from 1 to 22 carbon atoms, where one or more non-adjacent CH₂ groups may also be replaced by -O-, -S-, -SO₂-, -COO-, OOC- and/or phenylene, or an aryl or aryloxy group, where the aromatic unit in these groups may be substituted by C₁-C₂₂-alkyl, C₁-C₂₂-alkoxy, Br, Cl, F and/or CN, or Br, Cl, F, CN or alkyloxycarbonyl having from 2 to 23 carbon atoms;
R¹, R⁴, R⁵ and R⁸ are identical or different and are each a straight-chain or branched alkyl or alkoxy group having from 1 to 22 carbon atoms;
k is from 1 to 25;
n is from 3 to 200.

2. Polymer according to Claim 1, **characterized in that**, in the formulae (A) and (B) R², R³, R⁶, R⁷, R⁹, R¹⁰ are hydrogen.

3. Polymer according to at least one of Claims 1 and 2 consisting of structural elements of the formula (AₖB)ₙ.

4. Polymer according to Claim 3, **characterized in that** it is a homopolymer, a random copolymer or a block copolymer.

5. Polymer according to at least one of Claims 1 and 2, **characterized in that** it comprises not only at least one structural element of the formula (AₖB)ₙ but also one or more structural elements of the formula (VII), 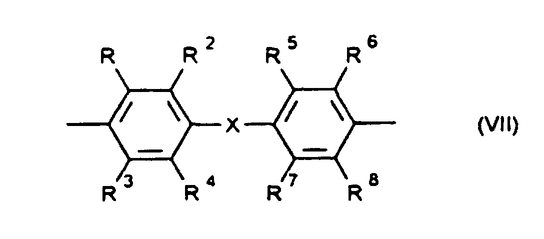 where R¹ to R⁸ have the meanings given for the structural element (AₖB)ₙ and X is a saturated hydrogen chain -(CH₂)ₙ- where n = 1-10 and one or more non-adjacent CH₂ groups may also be replaced by -O-, -S-, -SO₂-, -COO-, -OOC- and/or phenyl.

6. Polymer according to at least one of Claims 1 and 2, **characterized in that** it comprises not only at least one structural element of the formula (AₖB)ₙ but also one or more structural elements of the formula (VIII) 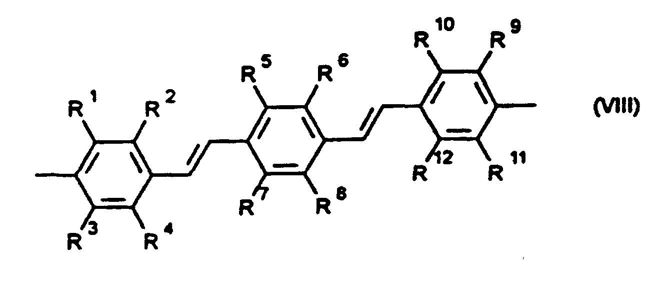 where R¹ to R⁴ have the meanings given for the structural element (AₖB)ₙ.

7. Use of a polymer according to at least one of Claims 1 to 6 as an electroluminescence material.

8. Electroluminescence material comprising one or more polymers according to at least one of Claims 1 to 6.

9. Electroluminescence device comprising one or more active layers, **characterized in that** at least one of these active layers comprises one or more polymers according to at least one of Claims 1 to 6.

## Revendications

1. Polymère renfermant des unités oligo-p-phénylène qui présente au moins un élément de structure de formule générale (AₖB)ₙ, les symboles et les indices possèdent les significations suivantes :
A identiques ou différents, représentent 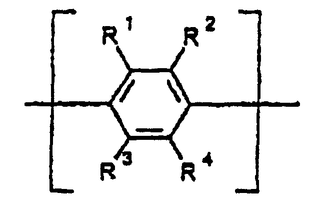
B identiques ou différents, représentent 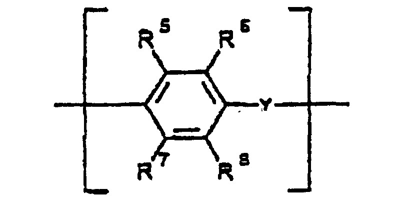
Y identiques ou différents représentent un groupe -CR⁹=CR¹⁰- ;
R², R³, R⁶, R⁷, R⁹, R¹⁰ représentent chacun des éléments de structure, indépendamment les uns des autres, identiques ou différents, un atome d'hydrogène, une chaîne alkyle linéaire ou ramifiée présentant 1 à 22 atomes de carbone, un ou plusieurs groupes CH₂ non adjacents pouvant aussi être remplacés par des groupes -O-, -S-, -SO₂-, -COO-, -OOC- et/ou phénylène, des groupes aryle ou aryloxy, le fragment aromatique dans ces groupes pouvant être substitué par des substituants alkyle en C₁-C₂₂, alkoxy en C₁-C₂₂, Br, Cl, F et/ou CN, Br, Cl, F, CN ou alkoxycarbonyle présentant 2 à 23 atomes de carbone ;
R¹, R⁴, R⁵ et R⁸ sont identiques ou différents et représentent un groupe alkyle ou alkoxy présentant 1 à 22 atomes de carbone ;
k va de 1 à 25 ;
n va de 3 à 200.

2. Polymère selon la revendication 1, **caractérisé en ce que**, dans les formules (A) et (B), R², R³, R⁶, R⁷, R⁹, R¹⁰ représentent des atomes d'hydrogène.

3. Polymère selon au moins l'une des revendications 1 ou 2, constitué par des éléments de structure de formule générale (AₖB)ₙ.

4. Polymère selon la revendication 3, **caractérisé en ce qu'**il est un homopolymère, un copolymère statistique ou un copolymère séquencé.

5. Polymère selon au moins l'une des revendications 1 ou 2, **caractérisé en ce qu'**il renferme en plus au moins un élément de structure de formule (AₖB)ₙ, un ou plusieurs éléments de structure de formule (VII), 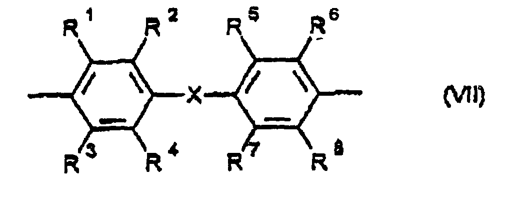 R¹ à R⁸ possédant les significations données aux éléments de structure (AₖB)ₙ et X représente une chaîne hydrocarbonée saturée -(CH₂)ₙ- avec n = 1 à 10, un ou plusieurs groupes CH₂ non adjacents pouvant aussi être remplacés par des groupes -O-, -S-, -SO₂-, -COO-, -OOC- et/ou phényle.

6. Polymère selon au moins l'une des revendications 1 ou 2, caractérisé en qu'il présente au côté d'au moins un élément de structure (AₖB)ₙ un ou plusieurs éléments de structure de formule (VIII) 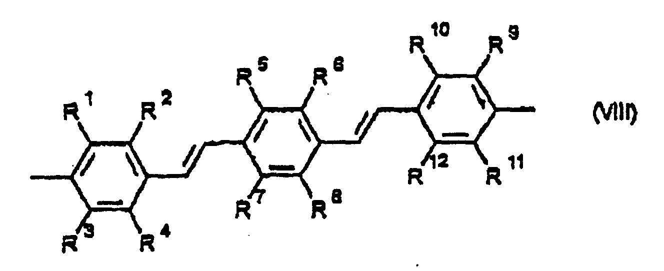 R¹ à R⁴ possédant les significations données à l'élément de structure (AₖB)ₙ.

7. Utilisation d'un polymère selon au moins l'une des revendications 1 à 6 en tant que matériau électroluminescent.

8. Matériau électroluminescent renfermant un ou plusieurs polymères selon au moins une des revendications 1 à 6.

9. Dispositif électroluminescent renfermant une ou plusieurs couches actives, **caractérisé en ce qu'**au moins l'une de ces couches actives renferme un ou plusieurs polymères selon au moins l'une des revendications 1 à 6.
